# EUROPÄISCHE PATENTSCHRIFT

(11) **EP 3 245 712 B1**
(45) Veröffentlichungstag und Bekanntmachung des Hinweises auf die Patenterteilung: **24.06.2020**
(21) Anmeldenummer: 15700463.1
(22) Anmeldetag: 15.01.2015
(51) Int. Cl.: H02K 5/22, H02K 5/08, H02K 11/33, H01R 13/405, H02K 5/10, H05K 3/28

(54) **ELEKTRISCHES KFZ-NEBENAGGREGAT**
AUXILIARY DEVICE FOR MOTOR VEHICLE
AGRÉGAT AUXILIAIRE ÉLECTRIQUE D'UN VÉHICULE

(43) Veröffentlichungstag der Anmeldung: 22.11.2017
(73) Patentinhaber: Pierburg Pump Technology GmbH, 41460 Neuss (DE)
(72) Erfinder: RATHKE, Ronald, 04720 Döbeln (DE); FINDEISEN, Alexander, 04720 Döbeln (DE)
(74) Vertreter: terpatent Patentanwälte ter Smitten Eberlein-Van Hoof Rütten Daubert
(86) Internationale Anmeldenummer: PCT/EP2015/050663
(87) Internationale Veröffentlichungsnummer: WO 2016/112980

(56) Entgegenhaltungen:
- EP-A1- 0 641 154
- EP-A1- 2 618 004
- EP-A2- 1 734 800
- WO-A1-2014/104121
- DE-A1-102004 024 718
- DE-A1-102009 009 091
- US-A- 5 909 915
- US-A1- 2006 011 012
- US-A1- 2006 057 002
- US-A1- 2007 069 841
- US-A1- 2008 304 988
- US-A1- 2013 320 792

## Beschreibung

Die Erfindung bezieht sich auf ein elektrisches Kfz-Nebenaggregat, beispielsweise auf eine elektrische Wasserumwälzpumpe.

Unter einem Kfz-Nebenaggregat sind vorliegend alle Aggregate zu verstehen, die nicht unmittelbar dem Antrieb des Kraftfahrzeuges (Kfz) dienen, sondern beispielsweise als Pumpe, Steller oder mechanischer Schalter ausgebildet sind. Der Antrieb des betreffenden Arbeitsmittels erfolgt bevorzugt durch einen elektronisch kommutierten Antriebsmotor, da die elektronische Kommutierung verschleißfrei ist und insbesondere bei Pumpen eine hermetische Trennung des Pumpenfluides und der Kommutierungselektronik ermöglicht, wenn der Antriebsmotor als sogenannter Spaltrohrmotor konzipiert ist.

Die Kommutierungselektronik befindet sich in der Regel im Wesentlichen auf einer Motorsteuerungs-Platine, die einseitig oder zweiseitig bestückt sein kann. Von der Motorsteuerungs-Platine aus führen Verbindungsleitungen zu einer peripheren Steckeranordnung, die an einem Gehäusekörper des Aggregatsgehauses angeordnet ist. In die Steckeranordnung kann nach der Montage des Kfz-Nebenaggregats in dem Kraftfahrzeug ein korrespondierender Gegenstecker eingesteckt werden, um das Kfz-Nebenaggregat elektrisch mit einer Fahrzeugsteuerung zu verbinden.

Der Zusammenbau des elektrischen Kfz-Nebenaggregats erfolgt in der Regel in axialer Richtung, wobei nach der Montage der Motorsteuerungs-Platine in einer Querebene, die ungefähr senkrecht zur Rotationsaxialen des Antriebsmotors orientiert ist, abschließend der Innenraum mit einem Gehäusekörper bzw. -deckel verschlossen wird. Der Gehäusekörper bzw. - deckel weist die Steckeranordnung auf, die elektrisch mit der Motorsteuerungs-Platine verbunden sein muss bzw. erst während des Zusammenbaus mit der Motorsteuerungsplatine verbunden wird. Für einen zuverlässigen Betrieb des Kfz-Nebenaggregats ist eine dauerhaft gute elektrische Verbindung der mindestens zwei freistehenden Steckerstifte der Steckeranordnung mit der Motorsteuerungs-Platine außerordentlich wichtig.

US 2008/0304988 A1, US 2006/0011012 A1 und US 2006/0057002 A1 offenbaren typische elektrische Kfz-Nebenaggregate mit einer Motorsteuerungs-Platine und einer peripheren Steckeranordnung für die elektrische Anbindung des Nebenaggregats an eine fahrzeugseitige Steuerung.

EP 2 618 004 A1, US 2007/0069841 A1, WO 2014/104121 A1 und US 2013/0320792 A1 offenbaren stationäre elektrische Pumpen bzw. Aggregate.

US 5,909,915 A, DE 10 2004 024 718 A1, EP 0 641 154 A1, EP 1 734 800 A2 sowie DE 10 2009 009 091 A1 offenbaren Elektronik-Platinen, die mindestens teilweise vergossen sind.

Aufgabe der Erfindung ist es, ein elektrisches Kfz-Nebenaggregat mit elektronischer Kommutierung zu schaffen, das eine hohe elektrische Zuverlässigkeit aufweist.

Diese Aufgabe wird erfindungsgemäß gelöst mit einem elektrischen Kfz-Nebenaggregat mit den Merkmalen des Anspruchs 1.

Das erfindungsgemäße elektrische Kfz-Nebenaggregat weist einen elektronisch kommutierten Antriebsmotor auf, der das Arbeitsmittel, beispielsweise ein Pumpenrad, antreibt. Die Motorsteuerung findet sich im Wesentlichen auf einer Motorsteuerungs-Platine, die bevorzugt in einer Antriebsmotor-Querebene angeordnet ist, also in einer Ebene quer zu der Rotationsaxialen des Antriebsmotors. Die Motorsteuerungs-Platine ist mindestens teilweise in einem Kunststoff-Vergusskörper vergossen, um die auf diese Weise vergossene Elektronik, die besonders bevorzugt eine Kommutierungselektronik ist, insbesondere vor Feuchtigkeit zu schützen.

Mit der Motorsteuerungs-Platine sind mehrere steife Metall-Stiftkörper elektrisch verbunden, beispielsweise verlötet, die auch an ihren freien Enden die Steckerstifte der peripheren Steckeranordnung bilden. Zwischen der elektrischen Verbindung der Stiftkörper mit der Motorsteuerungs-Platine und den Steckerstiften existiert also keine weitere Kontaktebene, wodurch die elektrische Zuverlässigkeit des Nebenaggregats grundsätzlich erhöht ist.

Der Vergusskörper weist einen einstückig angeformten Steckerkern auf, der die Stiftkörper derart umschließt, dass die Steckerstifte nichtvergossen sind, jedoch die Stiftkörper zwischen den Steckerstiften und der Motorsteuerungs-Platine vollständig in den Vergusskörper eingegossen sind. Der Steckerkern bildet an seinem distalen Ende einen Steckerboden, von dem aus die Steckerstifte emporragen. Die Steckeranordnung kann einen Steckerkragen aufweisen, der die Steckerstifte umgibt. Der Steckerkragen kann durch den Vergusskörper oder durch den Gehäusekörper gebildet sein.

Der Gehäusekörper verschließt das Aggregatsgehäuse und weist eine Gehäuseöffnung auf, in die der Steckerkern eingesteckt bzw. durch die der Steckerkern hindurchgesteckt ist, so dass der Steckerboden des Steckerkerns die Gehäuseöffnung vollständig verschließt.

Die Steckerstifte der Steckeranordnung werden also durch mehrere steife Metall-Stiftkörper gebildet, die unmittelbar mit der Motorsteuerungs-Platine elektrisch verbunden, beispielsweise verlötet, sind. Ferner ist die Motorsteuerungsplatine einschließlich der Steckerstifte durch einen monolithischen Vergusskörper zum Einen zuverlässig vor Feuchtigkeit geschützt und zum Anderen mechanisch zu einem einzigen steifen Gebilde geformt, so dass beispielsweise vibrationsbedingte oder montagebedingte Relativbewegungen zwischen den Steckerstiften bzw. den Stiftkörpern einerseits und der Motorsteuerungs-Platine andererseits praktisch ausgeschlossen sind. Alle beschriebenen Effekte zusammen ergeben eine hohe elektrische Zuverlässigkeit des Kfz-Nebenaggregats.

Der Vergusskörper weist mindestens zwei axiale Stütznasen auf, durch die der Vergusskörper axial an dem Gehäusekörper abgestützt ist. Besonders bevorzugt weist der Vergusskörper genau drei Stütznasen auf, durch die der Vergusskörper axial an dem Gehäusekörper abgestützt ist. Durch die Stütznasen wird der Vergusskörper einschließlich der Steckeranordnung in einem definierten Abstand und in einer definierten räumlichen Lage im Verhältnis zu dem Gehäusekörper angeordnet. Selbstverständlich können die Stütznasen erfindungsgemäß alternativ an dem Gehäusekörper vorgesehen sein.

Besonders bevorzugt weist der Gehäusekörper mindestens zwei axiale Stützpfannen auf, in denen die korrespondierenden Stütznasen axial abgestützt sind. Unter einer Stützpfanne ist grundsätzlich jede Form der Ausnehmung zu verstehen, in die die korrespondierende Stütznase hineinragen kann. Die Stützpfannen definieren auf diese Weise insbesondere die rotatorische Position des Vergusskörpers einschließlich der Steckeranordnung und der Motorsteuerungs-Platine im Verhältnis zu dem Aggregatgehäuse bzw. dem betreffenden Gehäusekörper. Hierdurch wird eine fehlerhafte Montage während des Zusammenbaus des Nebenaggregats zuverlässig verhindert. Besonders bevorzugt bilden die Stütznasen und die korrespondierenden Stützpfannen einen Formschluss, der beispielsweise die rotatorische Position, die radiale Position und die axiale Position des Vergusskörpers im Verhältnis zu dem betreffenden Gehäusekörper festgelegt. Selbstverständlich können die Stütznasen erfindungsgemäß grundsätzlich auch auf der Seite des Gehäusekörpers und die Stützpfannen auf der Seite des Vergusskörpers vorgesehen sein.

Gemäß einer bevorzugten Ausgestaltung sitzt der Steckerkern auf einem Steckersockel, der einen größeren lateralen Außenumfang aufweist als der Steckerkern. Zwischen dem Steckerkern und dem Steckersockel ist ein bevorzugt in einer Querebene liegender umlaufender Absatz gebildet, wobei zwischen der Absatz- Ringfläche und einer korrespondierenden gehäuseseitigen Dichtfläche eine elastische Ringdichtung angeordnet ist. Hierdurch wird in diesem Bereich eine zuverlässige fluidische Abdichtung des Gehäuse-Innenraums erreicht.

Die bevorzugt in einer Querebene angeordnete Motorsteuerungs-Platine weist eine proximale Seite und eine distale Seite auf. Unter der proximalen Seite ist die Seite der Platine zu verstehen, die dem Motorrotor und dem Motorstator axial zugewandt ist. Vorzugsweise ist eine oder sind beide Seiten mindestens teilweise durch den Vergusskörper vergossen bzw. bedeckt. Insbesondere sind jeweils die Partien der beiden Platinenseiten durch den Vergusskörper bedeckt, die mit elektronischen Bauelementen bestückt sind. Hierdurch werden die elektronischen Bauelemente derart fixiert und vor Korrosion geschützt, dass die elektrischen Lötverbindungen zwischen den elektronischen Bauelementen und den Leiterbahnen auf der Platine auch über einen langen Zeitraum nicht beschädigt werden.

Gemäß einer besonders bevorzugten Ausgestaltung sind der Steckerkern und die Gehäuseöffnung axial ausgerichtet. Hierdurch ist es beim axialen Zusammenbau des Nebenaggregats möglich, den Gehäusekörper axial auf einen zweiten Gehäusekörper aufzusetzen, der zusammen mit dem ersten Gehäusekörper das Nebenaggregat-Gehäuse bildet.

Vorzugsweise besteht der Vergusskörper aus einer Duroplast-Formmasse, Drucklast-Formmassen härten irreversibel und vollständig aus, so dass an der Grenzfläche zwischen dem Vergusskörper und den Steckerstiften auch langfristig kein Spalt auftreten kann, durch den beispielsweise Wasserdampf in dem Gehäuseinnenraum gelangen könnte. Ferner sind Duroplaste reaktiv, so dass eine stoffschlüssige Verbindung zwischen dem Vergusskörper- Duroplast und den Steckerstiften entstehen kann, die auch langfristig praktisch gasundurchlässig ist und bleibt.

Gemäß einer besonders bevorzugten Ausgestaltung bildet der Vergusskörper auch eine die Steckerstifte lateral umgebende Steckerfassung, wobei die Steckerfassung zusammen mit dem Steckerkern durch die Gehäuseöffnung hindurch nach außen ragt. Die Steckerfassung dient im Wesentlichen der Führung eines korrespondierenden Teils eines Gegensteckers.

Im Folgenden wird ein Aufführungsbeispiel der Erfindung näher erläutert. Es zeigen:
Figur 1 einen Längsschnitt eines erfindungsgemäßen Kfz-Nebenaggregats einschließlich einer in einen Vergusskörper eingegossen Motorsteuerungs-Platine,
Figur 2 eine perspektivische Ansicht des Vergusskörpers einschließlich eines Teils der Steckeranordnung des Kfz-Nebenaggregats der Figur 1, und
Figur 3 eine Teilansicht eines Längsschnitts der Steckeranordnung des Kfz-Nebenaggregats der Figur 1.

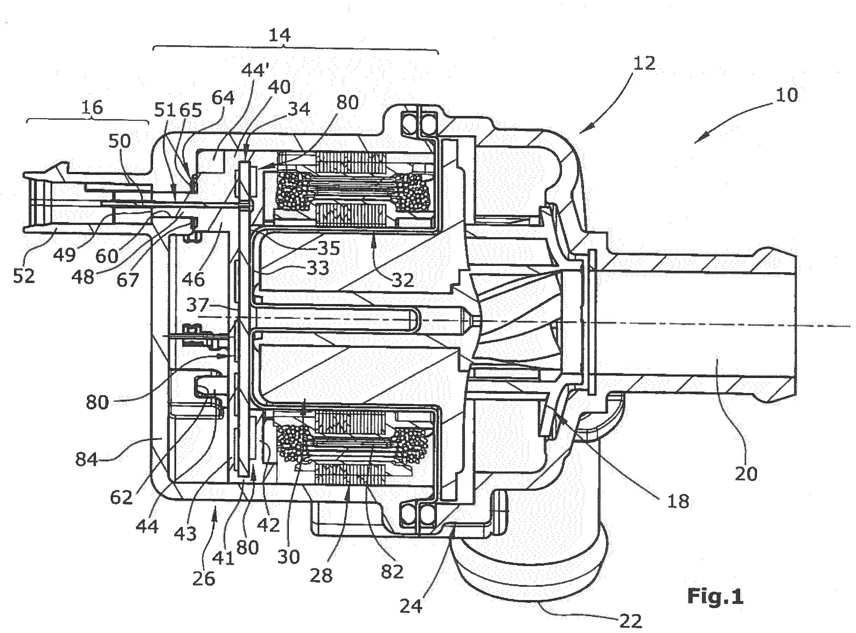

In der Figur 1 ist im Längsschnitt ein beispielhaft als Wasserumwälzpumpe ausgebildetes elektrisches Kfz-Nebenaggregat 10 dargestellt. Das Nebenaggregat 10 weist einen elektrischen Antriebsmotor 14 auf, der ein als Pumpenrad ausgebildetes Arbeitsmittel 18 koaxial antreibt. Das Kfz-Nebenaggregat 10 weist ein Gehäuse 12 auf, das im Wesentlichen aus einem ersten Kunststoff-Gehäusekörper 26 und aus einem zweiten Kunststoff-Gehäusekörper 24 in axialer Richtung zusammengesetzt ist. Der zweite Gehäusekörper 24 weist einen koaxialen und rohrartigen Pumpeneinlass 20 und einen tangentiale Pumpenauslass 22 auf. Der erste Gehäusekörper 26 ist topfartig ausgebildet und haust im Wesentlichen den Antriebsmotor 14 ein.

Der Antriebsmotor 14 ist als sogenannter Spaltrohrmotor ausgebildet und weist ein zylindrisches Spaltrohr 32 und einen in einer Querebene liegenden Topfboden 33 auf, wobei das Spaltrohr 32 und der Topfboden 33 zusammen einen sogenannten einstückigen Spalttopf bilden, der aus Kunststoff oder einem nicht-magnetischen Metall bestehen kann. Das Spaltrohr 32 trennt einen als Innenläufer ausgebildeten permanentmagnetisch erregten Motorrotor 30 in radialer Richtung von einem Motorstator 28, der in Umfangsrichtung mehrere Motorspulen 82 trägt. Der Antriebsmotor 14 weist ferner auf einer in einer Querebene liegenden Motorsteuerungs-Platine 34 eine Kommutierungselektronik 80 auf, durch die Motorspulen 82 des Motorstators 28 angesteuert bzw. bestromt werden. Unter einer Querebene ist eine Ebene zu verstehen, die annähernd senkrecht zu der Rotationsachse des Motorrotors 30 angeordnet ist.

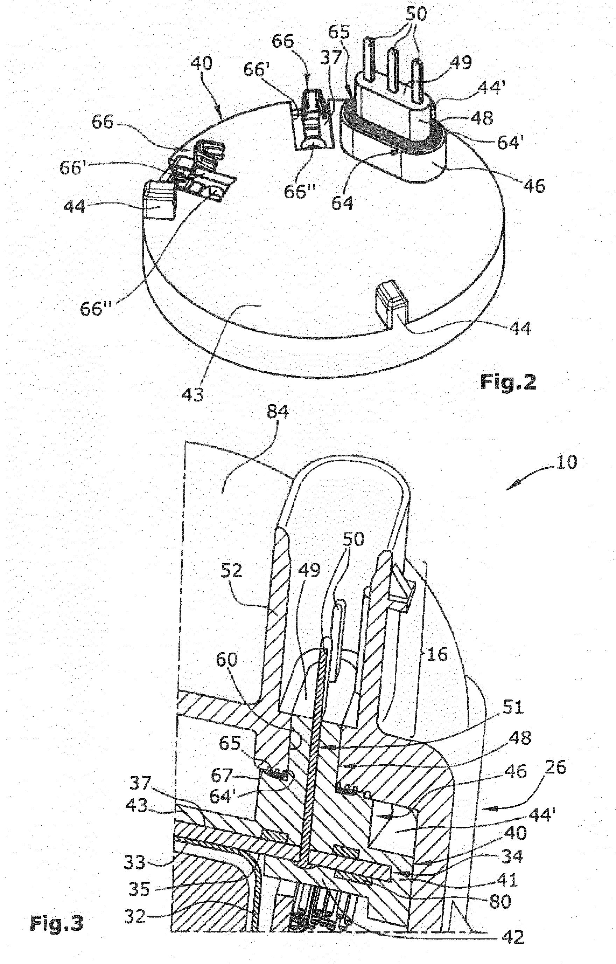

Die Motorsteuerungs-Platine 34 einschließlich der Kommutierungselektronik 80 ist zum größten Teil in einen monolithischen Vergusskörper 40 eingebettet bzw. eingegossen, der aus einem reaktiven Duroplast besteht. Der Vergusskörper 40 weist, wie insbesondere in der Figur 2 erkennbar ist, einen scheibenförmigen Teil 43, der die distale Seite 37 der Motorsteuerungs-Platine 34 nahezu vollständig abdeckt, einen ringförmigen Teil 42, der einen ringförmigen Randstreifen der proximalen Seite 35 der Motorsteuerungs-Platine 34 bedeckt, und einen zylindrischen Teil 41 auf, der den scheibenförmigen Teil 43 und den ringförmigen Teil 42 des Vergusskörpers 40 radial außenseitig einstückig miteinander verbindet.

Auf der distalen Seite weist der Vergusskörper 40 ferner einen axial von dem scheibenförmigen Vergusskörper-Teil 43 emporragenden Steckersockel 46 auf, an den sich axial wiederum ein Steckerkern 48 anschließt. Zwischen dem Steckersockel 46 und dem Steckerkern 48 ist ein umlaufender Absatz 64 gebildet, dessen Absatzfläche 64' ungefähr in einer Querebene liegt. Der Steckersockel 46 und der Steckerkern 48 umschließen drei Stiftkörper 51, die annähernd senkrecht von der Motorsteuerungs-Platine 34 in distaler Richtung axial emporragen und mit dieser verlötet sind. Die drei Stiftkörper 51 stehen ungefähr in einer Reihe, liegen also in einer einzigen Längsebene. Die drei Stiftkörper 51 sind axial länger als der Vergusskörper 40, wobei die den Vergusskörper 40 axial überragenden und freistehenden Abschnitte der Stiftkörper 51 drei Steckerstifte 50 einer Steckeranordnung 16 bilden.

Der erste topfförmige Gehäusekörper 26 weist eine im Wesentlichen zylindrische Umfangswand und eine im Wesentlichen in einer Querebene liegende kreisscheibenförmige Stirnwand 84 auf. Die Gehäusekörper-Stirnwand 84 weist eine axiale Gehäuseöffnung 60 auf, in die der Steckerkern 48 vollständig eingesteckt ist. An der proximalen Seite der Gehäusekörper-Stirnwand 84 ist eine umlaufende Dichtfläche 67 vorgesehen, die mit der Absatzfläche 64' korrespondiert. Zwischen der Dichtfläche 67 und der Absatzfläche 64' ist eine elastische Ringdichtung 65 angeordnet, die in diesem Bereich eine gasdichte Abdichtung des Gehäuseinnenraums gegenüber der Umgebung sicherstellt.

Die distale Stirnseite des Steckerkerns 48 bildet einen Steckerboden 49 der Steckeranordnung 16, der ungefähr in einer Querebene liegt.

Die Steckeranordnung 16 weist ferner eine Steckerfassung 52 auf, die die Steckerstifte 50 beabstandet umgibt. Die Steckerfassung 52 ist vorliegend einstückiger Teil der Gehäuse-Stirnwand 84, kann alternativ jedoch grundsätzlich auch von dem Vergusskörper 40 gebildet werden.

Auf der distalen Seite des Vergusskörpers 40 bzw. seines scheibenförmigen Teils 43 sind randseitig zwei Ausnehmungen 66' vorgesehen, da in diesem Bereich von der Motorsteuerungs-Platine 34 zwei Motorspulen-Klemmkontakte 66 emporragen, in denen in zusammengebauten Zustand des Nebenaggregats 10 jeweils ein durch entsprechende Öffnungen 66" hindurchtretende Stiftkontakte der Motorspulen 82 eingesteckt sind.

Auf der distalen Seite des Vergusskörpers 40 am Außenrand des scheibenförmigen Teils 43 sind ferner drei axiale Stütznasen 44,44' ausgebildet, die an drei korrespondierenden axialen Stützpfannen 62 an der proximalen Seite der Gehäuse-Stirnwand 84 abgestützt sind bzw. in diese formschlüssig eingreifen. Hierdurch werden zum Einen die exakte axiale Position des Vergusskörpers 40 und zum Anderen die rotatorische Position des Vergusskörpers 40 im Verhältnis zu dem Gehäuse eingestellt bzw. definiert.

## Patentansprüche

1. Elektrisches Kfz-Nebenaggregat (10) mit
einem Gehäuse (12),
einem elektronisch kommutierten Antriebsmotor (14),
einem von dem Antriebsmotor (14) angetriebenen Arbeitsmittel (18),
einer peripheren Steckeranordnung (16) mit mindestens zwei freistehenden Steckerstiften (50), und
einer mindestens teilweise in einem Vergusskörper (40) vergossenen Motorsteuerungs-Platine (34),
wobei die Steckerstifte (50) jeweils von einem einzigen steifen Stiftkörper (51) gebildet werden, der mit der Motorsteuerungs-Platine (34) unmittelbar elektrisch verbunden ist,
**dadurch gekennzeichnet, dass**
der Vergusskörper (40) einen einstückig angeformten Steckerkern (48) aufweist, der die Stiftkörper (51) zwischen der Motorsteuerungs-Platine (34) und einem von dem Steckerkern (48) gebildeten Steckerboden (49) umschließt, sodass die Stiftkörper (51) zwischen den Steckerstiften (50) und der Motorsteuerungs-Platine (34) vollständig in den Vergusskörper (40) eingegossen sind,
der Steckerkern (48) in einer Gehäuseöffnung (60) eines Gehäusekörpers (26) des Nebenaggregat-Gehäuses (12) steckt, so dass der Steckerboden (49) die Gehäuseöffnung (60) vollständig verschließt und die Stiftkörper (51) durch die Gehäuseöffnung (60) hindurch von dem Steckerboden (49) aus nach außen abragen, und der Vergusskörper (40) oder der Gehäusekörper (26) mindestens zwei axiale Stütznasen (44,44') aufweist, durch die der Vergusskörper (40) axial an dem Gehäusekörper (26) abgestützt ist.

2. Elektrisches Kfz-Nebenaggregat (10) nach Anspruch 1, wobei der Gehäusekörper (26) oder der Vergusskörper (40) mindestens zwei axiale Stützpfannen (62) aufweist, in denen die korrespondierenden Stütznasen (44,44') axial abgestützt sind.

3. Elektrisches Kfz-Nebenaggregat (10) nach einem der vorangegangenen Ansprüche, wobei der Steckerkern (48) auf einem Steckersockel (46) sitzt und zwischen dem Steckerkern (48) und dem Steckersockel (46) ein umlaufender Absatz (64) gebildet ist, wobei zwischen dem Absatz (64) und einer korrespondierenden gehäuseseitigen Dichtfläche (67) eine elastische Ringdichtung (65) angeordnet ist.

4. Elektrisches Kfz-Nebenaggregat (10) nach einem der vorangegangenen Ansprüche, wobei die Motorsteuerungsplatine (34) eine proximale Seite (35) und eine distale Seite (37) aufweist und die distalen Seite (37) und/oder die proximale Seite (35) mindestens teilweise durch den Vergusskörper (40) bedeckt ist/sind.

5. Elektrisches Kfz-Nebenaggregat (10) nach einem der vorangegangenen Ansprüche, wobei der Steckerkern (48) und die Gehäuseöffnung (60) axial ausgerichtet sind.

6. Elektrisches Kfz-Nebenaggregat (10) nach einem der vorangegangenen Ansprüche, wobei der Vergusskörper (40) aus einer Duroplast-Formmasse besteht.

7. Elektrisches Kfz-Nebenaggregat (10) nach einem der vorangegangenen Ansprüche, wobei das Arbeitsmittel (18) als Pumpenrad ausgebildet ist.

8. Elektrisches Kfz-Nebenaggregat (10) nach einem der vorangegangenen Ansprüche, wobei der Steckerkern und eine die Steckerstifte umgebende Steckerfassung von dem Vergusskörper gebildet werden, und die Steckerfassung durch die Gehäuseöffnung hindurch nach außen ragt.

## Claims

1. Motor vehicle secondary electric device (10) having
a housing (12),
an electronically commutated drive motor (14),
a working means (18) driven by the drive motor (14),
a peripheral connector arrangement (16) having at least two exposed connector pins (50), and
a motor control circuit board (34) at least partly potted in a cast body (40), wherein the connector pins (50) are each formed by a single rigid pin element (51), which is directly electrically connected to the motor control circuit board (34),
**characterized in that**
the cast body (40) has a connector core (48) that is integrally molded on in one piece and encloses the pin elements (51) between the motor control board (34) and a connector base (49) formed by the connector core (48), such that the pin elements (51) are completely potted in the cast body (40) between the connector pins (50) and the motor control board (34),
the connector core (48) is plugged into a housing opening (60) of a housing body (26), such that the connector base (49) closes the housing opening (60) completely, and the pin elements (51) project outward from the connector base (49) through the housing opening (60), and
the cast body (40) or the housing body (26) has at least two axial support noses (44, 44') by which the cast body (40) is axially supported at the housing body (26).

2. Motor vehicle secondary electric device (10) of claim 1, wherein the housing body (26) or the cast body (40) has at least two axial support sockets (62) in which the corresponding support noses (44, 44') are axially supported.

3. Motor vehicle secondary electric device (10) of one of the preceding claims, wherein the connector core (48) sits on a connector socket (46) and a circumferential shoulder (64) is formed between the connector core (48) and the connector socket (46), wherein an elastic ring seal (65) is arranged between the shoulder (64) and a corresponding housing-side sealing surface (67).

4. Motor vehicle secondary electric device (10) of one of the preceding claims, wherein the motor control circuit board (34) has a proximal side (35) and a distal side (37) and the distal side (37) and/or the proximal side (35) is/are at least partly covered by the cast body (40).

5. Motor vehicle secondary electric device (10) of one of the preceding claims, wherein the connector core (48) and the housing opening (60) are oriented in the axial direction.

6. Motor vehicle secondary electric device (10) of one of the preceding claims, wherein the cast body (40) is made of a thermoset molding compound.

7. Motor vehicle secondary electric device (10) of one of the preceding claims, wherein the working means (18) is designed as an impeller.

8. Motor vehicle secondary electric device (10) of one of the preceding claims, wherein the connector core and a connector frame surrounding the connector pins are formed by the cast body, and wherein the connector frame protrudes outward through the housing opening.

## Revendications

1. Agrégat auxiliaire électrique (10) d'un véhicule comprenant
un boitier (12),
un moteur d'entrainement à commutation électronique (14),
un moyen de travail (18) entrainé par le moteur d'entrainement (14),
un ensemble de connecteur périphérique (16) comprenant au moins deux broches de connecteur (50) exposées, et
une carte de circuit de commande de moteur (34) enrobée au moins partiellement dans un corps d'enrobage (40),
les broches de connecteur (50) étant chacune formées par un seul corps de broche rigide (51) directement connecté électriquement à la carte de commande de moteur (34),
**caractérisée en ce que**
le corps d'enrobage (40) présente un noyau de connecteur (48) moulé intégralement sur celui-ci, qui entoure les corps de broche (51) entre la carte de circuit de commande de moteur (34) et une base de connecteur (49) formée par le noyau de connecteur (48), de sorte que les corps de broche (51) soient entièrement enrobés dans le corps d'enrobage (40) entre les broches de connecteur (50) et la carte de circuit de commande de noteur (34),
le noyau de connecteur (48) est enfiché dans une ouverture de boitier (60) d'un corps de boitier (26), de sorte que la base de connecteur (49) ferme complètement l'ouverture de boitier (60) et les corps de broche (51) font saillie à travers l'ouverture de boitier (60) vers l'extérieur à partir de la base de connecteur (49), et
le corps d'enrobage (40) ou le corps de boitier (26) comprend au moins deux nez de support axial (44, 44'), par lesquelles le corps d'enrobage (40) est supporté axialement sur le corps de boitier (26).

2. Agrégat auxiliaire électrique (10) d'un véhicule selon la revendication 1, dans laquelle le corps de boitier (26) ou le corps d'enrobage (40) comprend au moins deux plateaux de support (62) axiaux dans lesquels les nez de support (44, 44 ') correspondants sont supportées axialement.

3. Agrégat auxiliaire électrique (10) d'un véhicule selon l'une quelconque des revendications précédentes, dans laquelle le noyau de connecteur (48) se trouve sur une base de connecteur (46) et un épaulement circonférentiel (64) est formé entre le noyau de connecteur (48) et la base de connecteur (46), un joint annulaire élastique (65) étant disposé entre l'épaulement (64) et une surface d'étanchéité côté boitier (67) correspondante.

4. Agrégat auxiliaire électrique (10) d'un véhicule selon l'une quelconque des revendications précédentes, dans laquelle la carte de commande de moteur (34) présente un côté proximal (35) et un côté distal (37) et le côté distal (37) et/ou le côté proximal (35) est au moins partiellement recouvert par le corps d'enrobage (40).

5. Agrégat auxiliaire électrique (10) d'un véhicule selon l'une quelconque des revendications précédentes, dans laquelle le noyau de connecteur (48) et l'ouverture de boitier (60) sont alignés axialement.

6. Agrégat auxiliaire électrique (10) d'un véhicule selon l'une quelconque des revendications précédentes, dans laquelle le corps d'enrobage (40) est formé d'un composé de moulage thermodurcissable.

7. Agrégat auxiliaire électrique (10) d'un véhicule (10) selon l'une quelconque des revendications précédentes, dans laquelle le moyen de travail (18) est conçu comme une roue de pompe.

8. Agrégat auxiliaire électrique (10) d'un véhicule selon l'une quelconque des revendications précédentes, dans laquelle le noyau de connecteur et un embout de connecteur entourant les broches de connecteur sont formés par le corps d'enrobage, et l'embout de connecteur fait saillie à travers l'ouverture du biîtier vers l'extérieur.
